**Europäisches Patentamt**

**European Patent Office**

**Office européen des brevets**

(19)

(11)　**EP 1 312 971 A2**

(12) ## EUROPEAN PATENT APPLICATION

(43) Date of publication:
　　　21.05.2003　Bulletin 2003/21

(51) Int Cl.[7]: **G02F 1/025**, H01S 5/026,
　　　G02B 6/122, G02B 6/136

(21) Application number: 02257790.2

(22) Date of filing: 11.11.2002

(84) Designated Contracting States:
**AT BE BG CH CY CZ DE DK EE ES FI FR GB GR IE IT LI LU MC NL PT SE SK TR**
Designated Extension States:
**AL LT LV MK RO SI**

(30) Priority: **17.11.2001　GB 0127573**

(71) Applicant: **CORNING INCORPORATED**
**Corning, N.Y. 14831 (US)**

(72) Inventors:
• **Rogers, David Carnegie**
**Ipswich, Suffolk IP4 5DF (GB)**

• **Moodie, David Graham**
**Hasketon, Suffolk IP13 6LA (GB)**
• **Lealman, Ian Francis**
**Ipswich, Suffolk IP5 2BL (GB)**
• **Perrin, Simon David**
**Ipwich, Suffolk IP4 4DY (GB)**

(74) Representative: **Poole, Michael John et al**
**Corning Communications Ltd.,**
**Patent and Licensing Dpt.,**
**Quantum House,**
**Maylands Avenue**
**Hemel Hempstead, Herts. HP2 7DE (GB)**

(54)　**Semiconductor optical devices and methods of making them**

(57)　An optical monomode guided-wave device, especially an electroabsorption modulator, having an active region (18) with a mode size small compared with that of an optical fibre is integrated with at least one passive spot size adjuster (tapered region (14)) which has an optical core that tapers simultaneously from a width and height substantially equal to those of the active region adjacent to that region to a width large compared with the width of the active region and a thickness substantially smaller than the thickness of the active region. Usually - unless the device includes its own light source (35)- there will be two spot size adjusters.

The device is a buried hetero-structure device; its optical core tapers smoothly in both width and height; the dimensions of the core are such that there is an optical transmission mode for which the effective refractive index difference between the mode and any other mode (including the radiation field) is large enough to ensure that no more than 20% (preferably 5%) of light entering one end of the guided wave device in that mode will (or would) be lost (or gained) by radiation.

The simultaneous smooth tapers can be obtained by taking advantage of the characteristics of the mass-transport limited MOVPE technique, depositing in a narrow channel defined between two deposit-resist bands, the thickness deposited, at least in the centre of the channel, varying in a direct sense with the widths of the adjacent bands and in an inverse sense with the width of the channel.

Figure 9

EP 1 312 971 A2

## Description

This invention relates to optical guided wave devices based on semiconductor materials and to methods of making them. Its primary application and benefit is expected to be in semiconductor electro-absorption modulators (EAM's), including integrated laser Modulators (ILM's); but it may also be used, for example, in semiconductor optical amplifiers or semiconductor lasers.

It is a practical necessity for EAM's, and may be desirable for other such devices, for the active region of the semiconductor to be of small diameter relative to the mode field diameter of normal optical fibres; typically the guided mode in an EAM is around 2μm in diameter, compared with 8-10μm in typical silica-based optical fibres. Coupling can be satisfactorily achieved using lensed fibres (or separate lenses), but this is expensive and difficult because the alignment tolerances are so restrictive (typically ± 1μm is not accurate enough) that automated alignment in manufacture has so far proved time-consuming and expensive.

A number of research groups have reported attempts to integrate with such optical devices waveguide sections designed to increase the mode field diameter away from the device proper ("beam expanders" or "spot size converters"), but they have not been fully satisfactory for high-speed switching devices such as EAM's, owing to high capacitance, light losses, reflections, or other causes. It is noted that (as is known) the mode field diameter of an optical waveguide is a minimum for some particular core dimension, and that an increase in mode field diameter can be obtained by increasing the core dimension above that corresponding to the minimum or by decreasing dimension below it, but with the proviso that reducing the core dimension substantially below the minimum reduces the difference in effective refractive index between the guided mode and the radiation field (because a large part of the mode is in the cladding) and if taken too far is likely to increase losses. A compromise that sometimes proves valuable is to increase dimension in one plane while simultaneously reducing the dimension in the perpendicular direction, ideally so that the mode field remains always substantially circular. For example:

*Devaux et al, Optical Fibre Communications Conference 1996, Technical Digest Series, ISBN 155752422X, pages 208-9* reports a deep-ridge waveguide EAM with a spot-size converter in which the width of the ridge increases away from the active region while its height reduces in a series of steps obtained by successive masking and etching operations. This structure was designed to facilitate coupling with lenses, not directly to cleaved fibres, and has the disadvantages of relatively high propagation losses in the taper areas and unwanted reflections at the steps.

*Takahashi et al, IEICE Trans Electron, E83-C no 6 pp 845-854 (June 2000)* describes a numerical analysis of theoretical designs for ridge- and buried hetero-structure waveguide diode lasers integrated with spot size converters in which the thickness of the optical core layers decreases while their width increases or remains constant, but does not clearly define the structure of the buried-hetero-structure variant and offers no teaching as to how such devices might be made.

*Koren et al, Electronics* Letters *30 1852-3,* reports a rather different experimental arrangement for an EAM, using vertical coupling with an underlying passive waveguide; in our judgement, this is unsatisfactory for an EAM, first because the inevitable additional capacitance between the passive guide and the upper contacting layer would seriously compromise the potential bandwidth of the device by increasing capacitive charging time, and second because of the risk of substantial light leakage into (and out of) parasitic modes.

*Huber et al, IEEE Photonics Technology Letters 13 (no.10) October 2001, 1064-1066* and related US6317445 (Coleman et al) describe ridge (or rib) laser structures in which a ridge is smoothly tapered both to increase in width and to decrease in thickness to increase the mode field size at the facet, apparently in order to reduce facet intensity and reduce risk of catastrophic optical damage, but this application necessarily requires the taper to be in the active laser cavity of the device. Neither adaptation to a buried-heterostructure device nor extension to a passive device could be made without major difficulty, even if there were motivation to do so.

The present invention provides a structure, and a practicable method of making it, in which these difficulties are avoided and a close match between the mode sizes of the device and the fibre can be achieved.

In accordance with one aspect of the invention, an optical monomode guided-wave device, especially an EAM, having an active region with a mode size small compared with that of an optical fibre is integrated with at least one passive spot size adjuster which has an optical core that tapers simultaneously from a width and height substantially equal to those of the active region adjacent to that region to a width large compared with the width of the active region and a thickness substantially smaller than the thickness of the active region at a position remote from that region and is *characterised in that* it is a buried hetero-structure device, *that* the optical core tapers smoothly in both width and height, *that* the dimensions of the core are such that there is an optical transmission mode for which the effective refractive index difference between the mode and any other mode (including the radiation field) is large enough to ensure that no more than 20% (and preferably no more than 5%) of light entering one end of the guided wave device in that mode will (or would) be lost (or gained) by radiation *and that* the mode size at the distal end of the spot-size adjuster is substantially larger than its mode size in the active region.

It will be appreciated that radiation losses will substantially all arise in the tapered part of the device and will be made up of loss by scattering and loss by coupling. The conditions for limiting radiation losses to a particular level automatically ensure that entry of stray light (which degrades signal:noise ratio) is restricted to the same level; and of course it is immaterial if light actually enters the device or is generated within it.

Preferably the effective refractive index difference for the chosen mode is everywhere at least 0.001, preferably at least 0.002 (and much greater in the active region).

Preferably the device is a monomode device.

The width of the core is to be considered the direction of its largest transverse dimension; usually but not necessarily this will be parallel to the major surfaces of the chip on which the device is formed. Preferably the width of the core tapers to at least 5 times its value in the active device, more especially at least 8 or 10 times. Preferably it tapers in height (the perpendicular transverse dimension) below 0.4 times its value in the active device, and more especially to about 0.2 times, but not usually below 0.1 times, because of the need to maintain a sufficient effective refractive index difference.

Naturally, the tapers should be designed to contain the active mode or modes as near completely as is consistent with other requirements, including in particular a practicable taper length. Using a taper which reduces in height and simultaneously increases in width in accordance with the present invention, a reasonable approximation to the ideal "adiabatic" taper from which no light radiates can be achieved in a length of the order of 1mm for typical current device and optical fibre dimensions. Using a taper which reduces in both planes simultaneously, this is nowhere near achievable in a length of 5mm.

Guidance for the determination of a satisfactory taper can be obtained from published sources, for example the paper by J D Love in IEE Proc J 1989, vol **136** no.4 pp 225-228. For a single-mode waveguide, any change in dimensions tends to couple power from the excited transmission mode into the radiation mode, and the coupling length for this interaction is generally taken to be

$$Z_b = 2\pi/(\beta_1 - \beta_2)$$

where $\beta_1$ and $\beta_2$ are the propagation constants for the guided mode and the radiation mode respectively. The propagation constants can be written as

$$\beta_1 = 2\pi n_1/\lambda$$

and

$$\beta_2 = 2\pi n_2/\lambda$$

where $n_1$ is the effective refractive index for the guided mode, $n_2$ the refractive index of the surrounding material, and $\lambda$ the wavelength exciting the guided mode. For a step-index fibre or other circular waveguide, the beat length is defined in terms of local taper angle $\omega$ = arctan (dR/dz), where R is the local core radius. For an adiabatic taper, the taper angle must be everywhere $\leq R(\beta_1-\beta_2)/2\pi$.

For a rectangular guide, a reasonable approximation is obtained by substituting for R the value $\sqrt{(AB/\pi)}$, where A and B are the local width and length. This approximation gives the permissible taper angle as

$$\omega \leq [(n_1-n_2)/\lambda]\sqrt{(AB/\pi)}.$$

This is difficult to solve, since $n_1$, A and B all vary along the length of the taper and in dependence on $\omega$ (but it will be immediately apparent that there will be difficulties if the values of $n_1$ and $n_2$ approach each other, as they inevitably would for a guide that tapered inwardly in both planes).

Preferably the composition of the optical core also varies smoothly through the spot size adjuster such that its bandgap is substantially greater than that in the active region, ensuring that the taper regions will remain inactive (non-absorbing) even if they are subjected to electrical field. Specific compositions will be described in the context of a method of manufacture.

When the device is a modulator or another device that light passes through, preferably it is integrated with two spot size converters as described, one at the input and one at the output side of the device.

When the device is an integrated laser-modulator, a laser, or any device that is, or includes, a light source, it will usually need to be integrated with only one spot size converter as described, at the output side of the device.

The invention includes a method of making the structure described which is *characterised* by the steps of

(i) applying to a semiconductor substrate at least one pair of bands of a deposition-resist material between which a channel of the substrate is exposed, the channel having a first section where its own width and the widths of the bands are both uniform and at least one section where the bands taper inwardly and/or the channel tapers outwardly from at least one of the ends of the first section (and preferably both);

(ii) forming a ridge of at least one semiconductor optical core material in the channel by a metal-organic vapour phase epitaxy technique under mass-transport-limited conditions;

(iii) masking and etching the ridge so made to produce a core with controlled dimensions including a width everywhere substantially less than the corresponding width of the channel and also including the specified tapers; and

(iv) enclosing the etched ridge in optical cladding material.

Conducting metal-organic vapour phase epitaxy under mass-transport-limited conditions has the effect that the thickness of epitaxial growth is enhanced adjacent to deposit-resistant material, and the result in the present context is that the thickness (height) of the ridge will be greater where the width of the channel is less and/or the width of one or both of the adjacent bands is (within limits) greater.

Preferably the process will be applied to the manufacture of a plurality of devices on a chip, and the requirements of crystal orientation will normally require the channels for the individual devices to be parallel to one another.

Preferably the widths of both of the bands of deposition-resist material constituting a pair are the same at each position along their length, and preferably the bands taper inwards from both sides with consequent outward tapering of the channel. Preferably the taper is symmetrical and preferably it extends to a point at the end of the band.

Preferably the bands are formed by first depositing a uniform layer of deposition-resist material, such as silica, on a semiconductor chip substrate, printing and patterning a photoresist on the uniform layer corresponding to the desired bands, and etching to reproduce the photoresist pattern in the deposition-resist material.

Preferably the ridge is formed (at least in its passive portions) of an alloy semiconductor comprising at least two of indium, gallium, and aluminium, and at least one of phosphide and arsenide, preferably in multiple layers. Other materials may be required in the active region of the device. In the indium/gallium case (for example), because organo-indium molecules diffuse more rapidly than equivalent organo-gallium molecules, the concentration of indium will be higher in the central parts of the ridge, more especially near the proximal end (s) of the beam expander(s) where its thickness is greatest: this is beneficial, as the higher-energy bandgap of the gallium-rich alloy composition results in lower optical absorption at the operating wavelength. Similar effects will occur with other combinations of metal-organic compounds.

In the diffusion-limited conditions, the ridge will initially be deposited with pronounced thickness maxima close to its edges, and a central area where the thickness is substantially uniform across its width; preferably the etching step completely removes the outer, thicker parts leaving the finished ridge of substantially uniform thickness across its width.

Preferably the cladding material (including the initial surface on which the ridge is to be deposited) is indium phosphide, preferably on a substrate with a (100) oriented surface. Alternatives include gallium arsenide, some other III-V and II-VI compounds, and silicon, germanium and their alloys.

The invention will be further described, by way of example only, with reference to the accompanying drawings in which:

Figure 1 is a partial plan view of a semiconductor chip on which a number of pairs of bands of deposit-resist material have been formed in the manufacture of a first electro-absorption modulator in accordance with the invention;

Figure 2 is an enlarged fragmentary cross-section corresponding to the line A-A in Figure 1 and showing a stage of ridge growth;

Figure 3 is a plan view of a portion of the device being made, when ready for the etching step;

Figure 4 is a cross-section, corresponding to the line B-B in figure 3, showing the device at the completion of the etching step;

Figure 5 is a cross-section, corresponding to Figure 4, after a number of additional steps;

Figure 6 is a plan view illustrating the addition of an dielectric layer;

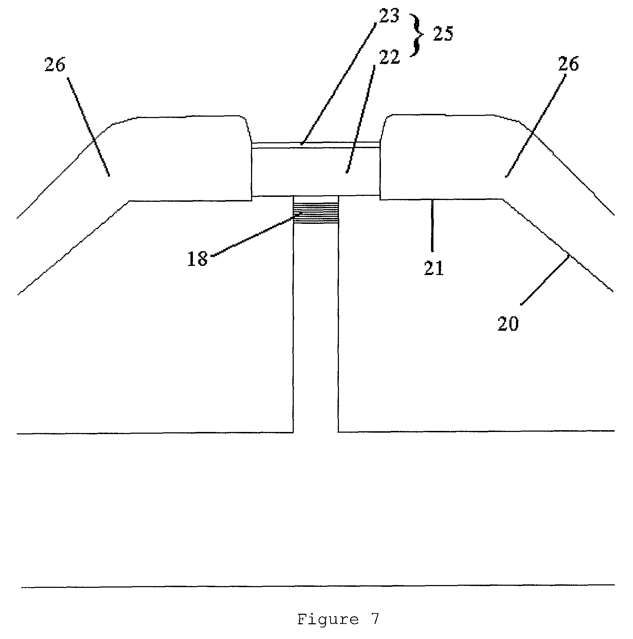

Figure 7 is a further cross-section on the line C-C at the stage corresponding to Figure 6;

Figure 8 is a cross-section on the line D-D in Figure 6;

Figure 9 is a diagrammatic, partly cut-away perspective view of one module of a completed EAM of this first kind;

Figure 10 is a plan view of an alternative embodiment;

Figure 11 is a cross-section on the line E-E in Figure 10, and so corresponds to Figure 7;

Figure 12 is a view, corresponding to Figure 9, of a completed EAM of this alternative kind;

Figure 13 is a plan view of part of a semiconductor chip on which a number of pairs of bands of deposition-resist material have been formed in the manufacture of an ILM in accordance with the invention;

Figure 14 is a cross-section along the centre of the active stripe of the first ILM to be described; and

Figures 15 and 16 are diagrammatic, partly cutaway perspective views of one module respectively of that ILM and a modified ILM in accordance with the invention.

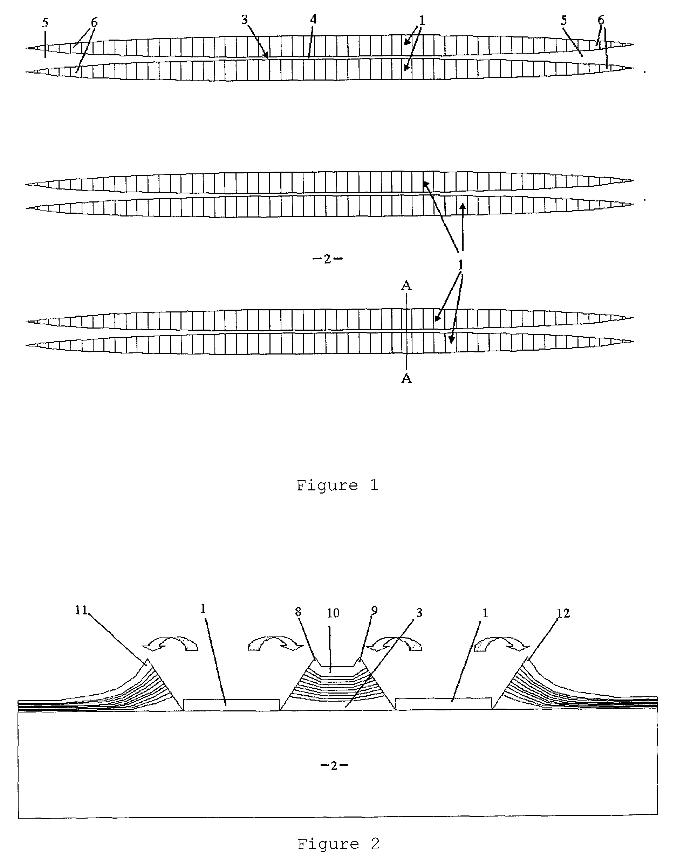

Figure 1 shows three symmetrical pairs of deposit-resist bands 1 of silica formed (by pattern etching an initially uniform coating) on the (100) surface of an n-type indium phosphide chip substrate 2 in preparation for the manufacture of an array of EAM's in accordance with the invention. A p-type substrate could also be used, and the modifications to accommodate this are straightforward and do not need to be described separately. Each pair of bands defines a deposition channel 3 comprising a middle section 4 of uniform width and extending along the <011> direction of the crystal and end sections 5 which gradually increase in width due to tapering of the corresponding end-parts 6 of the bands. As shown, and as preferred, these end-parts each taper equally from both sides and the bands each terminate in a point to minimise discontinuity.

The chip, so prepared, is subjected to epitaxial growth of multiple layers by the metal-organic vapour-phase technique under mass-transport-limited conditions (a process that is known *per se*) using a mixed vapour of trimethyl indium, trimethyl gallium, phosphine and arsine. The silica bands inhibit deposition, resulting in a net diffusion of reagents outwards over the edges of the bands, and so (as seen in Figure 2) in increased thickness of deposit adjacent the edges. The effects of the two inner edges of the two bands defining the channel 3 overlap, with the result that the deposit forms a ridge with a cross-section comprising two lateral peaks 8, 9 spaced from one another by a plateau area 10 of substantially uniform thickness. As the widths of the bands decreases towards their ends, the increase in ridge thickness that they produce smoothly decreases and eventually disappears a short distance beyond their ends. Further, because trimethyl indium diffuses faster than trimethyl gallium, the proportion of indium is higher where the thickness of the deposited layer is greater and ridge is narrower. Deposits 11, 12 on the outer sides of the bands are not needed as part of the product, but allowing their formation helps optimise the shape of the deposit in the channel 3.

The vapour compositions used to form the successive layers are adjusted, in a way known *per se,* to form multiple-quantum-well and separate confinement heterostructure layers in the central region of the device, to establish it as an active, electroabsorption modulating, region.

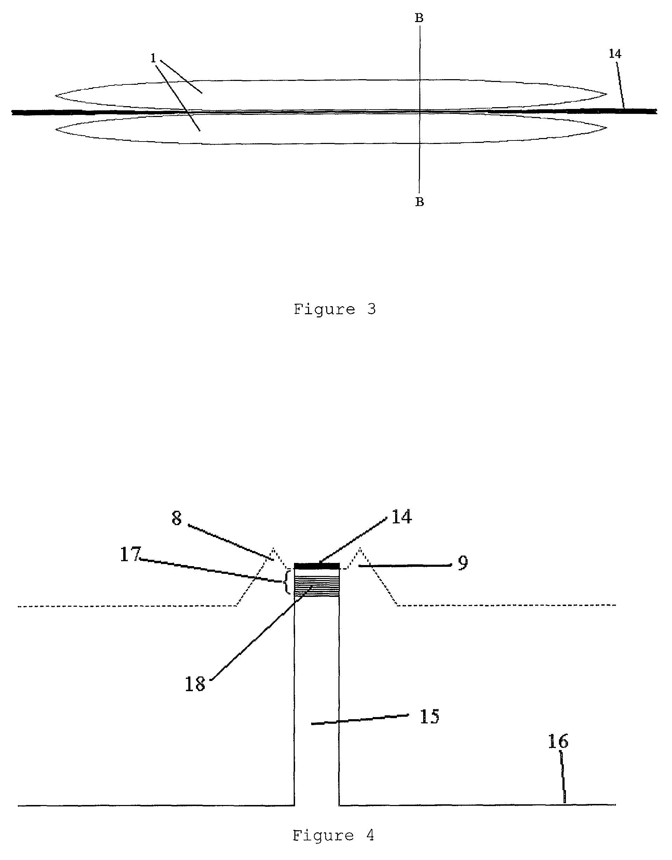

Once deposition is complete (figures 3 and 4), the bands 1 are removed and an etch mask 14, similar in shape to the deposited ridge but significantly narrower throughout and generally of controlled dimensions, is centrally applied to the ridge by conventional coating and pattern-etching techniques, and the chip is etched using reactive-ion etching in a methane/hydrogen plasma. This removes all the deposit formed on the surface of the chip and not now protected by the mask, including in particular the peaks 8 and 9, plus a substantial thickness of the original chip, forming a high ridge 15 and an etched surface 16. The upper part 17 of the ridge, including at its centre the active region 18, is to constitute the core of the eventual wave-guide. It includes end parts that gradually increase in width and simultaneously decrease in thickness as described.

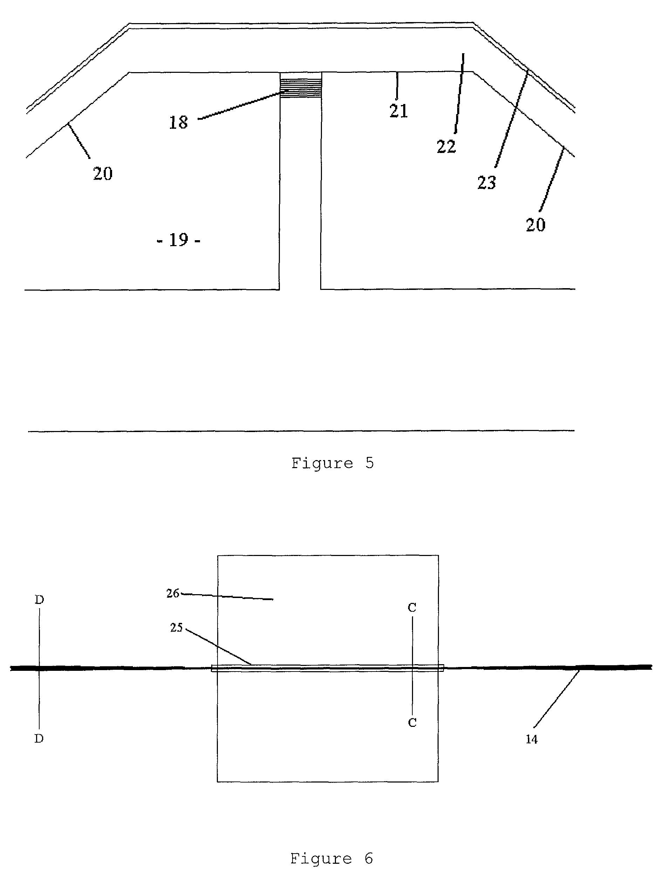

The sides of the high ridge 15 are now enclosed in semi-insulating Fe-doped indium phosphide 19 (Figure 5) by the "replanarising" MOVPE technique using vapours including phosphorus trichloride (*Planarised InP Regrowths around Tall and Narrow Mesas using Chloride-MOVPE,* Perrin et al, Proc Eleventh Int Conf InP Related Materials, Davos 1999 page 63;

*The influence of PCl$_3$ on Planarisation and Selectivity of InP Regrowth by Atmospheric Pressure MOVPE*, Harlow et al, Proc Seventh Int Conf InP Related Materials, Sapporo, 1995, page 329). This selectively builds the crystal surface 20 until it reaches the top of the ridge when the (100) plane 21 appears. The etch mask is then removed and a p-type layer of indium phosphide 22 and a contact layer of heavily p-doped indium gallium arsenide 23 applied over the active region 18.

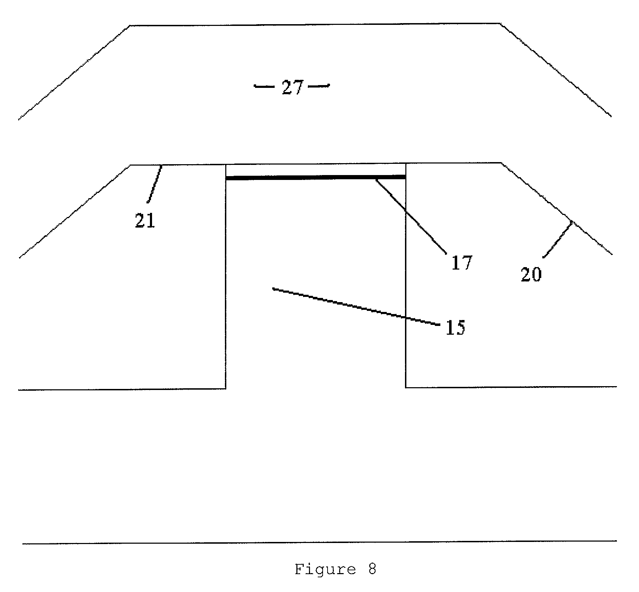

These layers 22 and 23 are now pattern etched to leave only a narrow contact strip 25 over the active region 18 (Figures 5 and 6). A thick dielectric layer 26 is deposited over the entire device and pattern etched to uncover the tapered regions 14; this may be of arsenic doped silicate glass, silicon oxy-nitride or other suitable electrically insulating material. Where the tapered regions 14 are exposed, a further layer 27 of semi-insulating iron-doped indium phosphide is grown by low-pressure metal-organic vapour phase epitaxy (without phosphorus trichloride), as seen in Figure 8, a section where the optical core 17 is considerably wider and considerably thinner than in the active region.

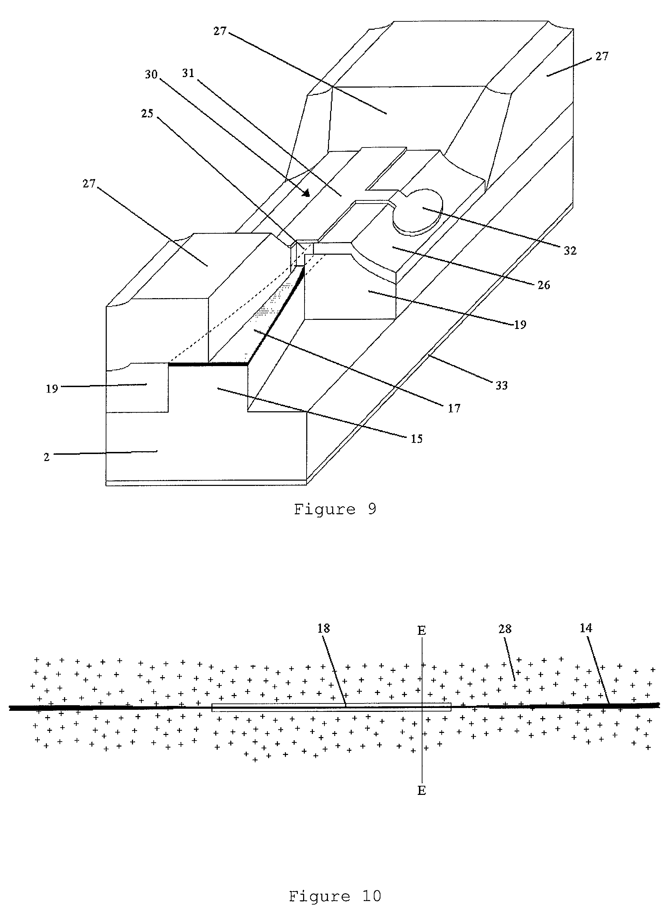

Next (Figure 9) a gold contact 30 is applied to the indium-gallium arsenide contacting layer using titanium and platinum inter-layers (not shown). The gold contact and the inter-layers are pattern etched to leave a narrow metal strip 31 over the contacting layer, with an extension 32 to form an external connection point spaced from the active area.

Finally, after the usual thinning step, a gold countercontact 33 is applied to the substrate 2 using a titanium inter-layer (not shown). Individual devices or arrays of devices are separated by scribing and cleaving.

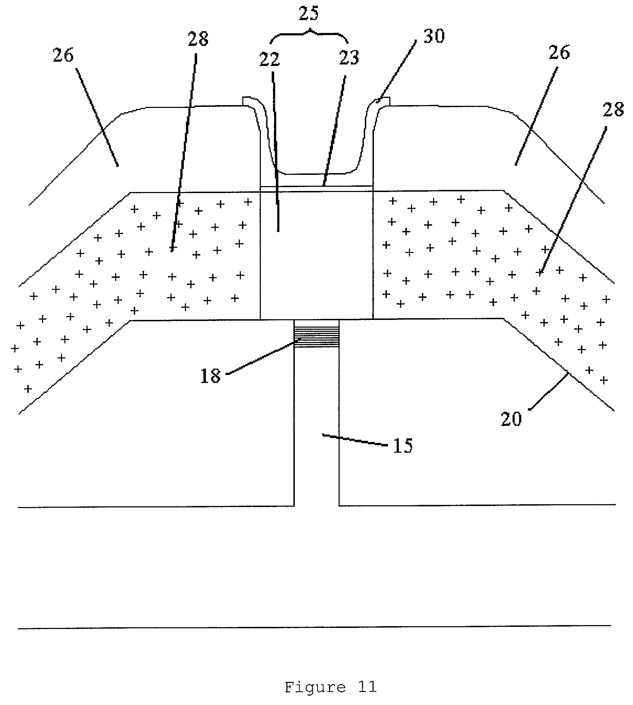

Figures 10-12 illustrate an alternative to the use of the two separate layers 26 and 27; instead an overall p-type indium phosphide layer 28 is used and electrical insulation achieved by proton implantation. The indium-gallium arsenide contacting layer 23 is then pattern etched to leave a narrow strip over the active region 18. A thick dielectric layer 26 is deposited over the entire surface of the device and subsequently pattern etched to uncover the contacting layer 23 to which contact 30 is applied, generally as before.

By way of indicating scale, it is envisaged that the active EAM section of the device shown in Figure 9 might be 100 µm long, and each of the tapered spot-size adjusters 1000 µm long; the ridge width 1 µm in the active region, tapering to 5 µm at each end; the waveguide core (part 17) may be 0.25 µm high in the active region, tapering to 0.05 µm at the ends; the ridge etch depth 5 µm and dielectric thickness 3µm.

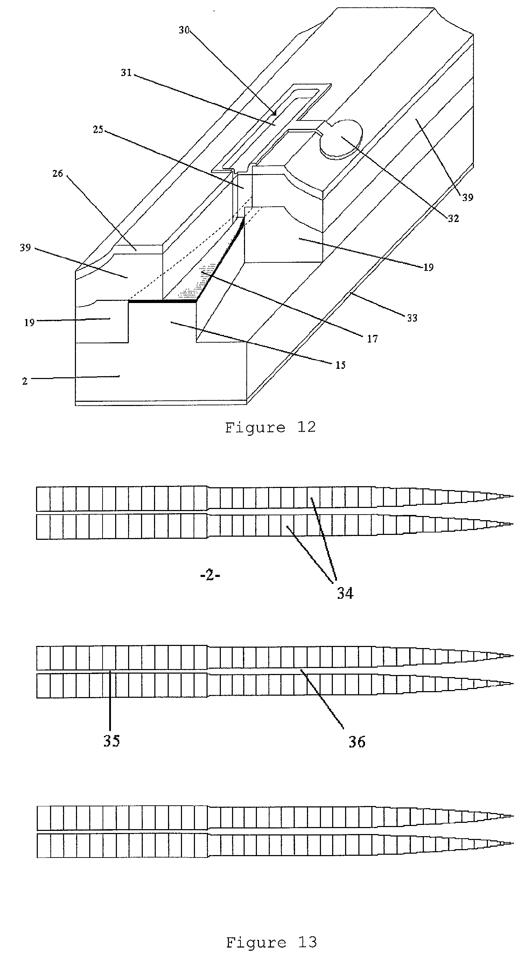

Figure 13 shows a form of deposit-resist bands 34 that can be used in fabricating an ILM in accordance with the invention. The arrangement differs from Figure 1 in that the channel width is narrower and the band width greater in the region 35 where the laser section of the device is to be formed compared to the region 36 where the modulator section is to be formed. In the narrower part 35 of the channel the greater quantum well thicknesses and greater indium content of the layers grown will result in a smaller semiconductor band-gap than that in the wider part 36. This allows the emission wavelength of the laser section to be optimised independently of the operating wavelength of the modulator section.

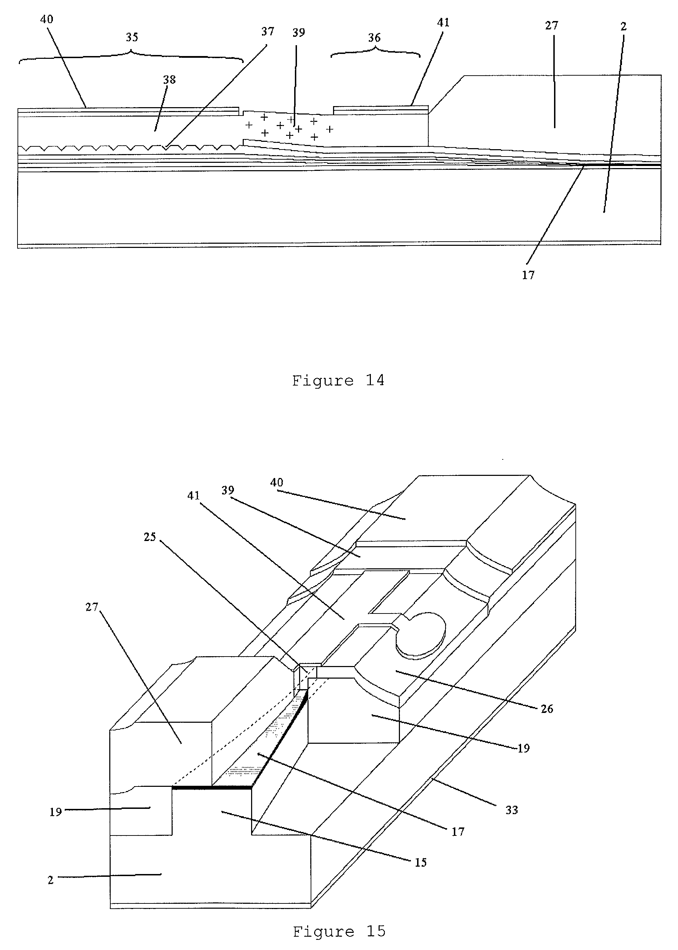

Figure 14 shows a cross-section along the propagation direction of the completed ILM. Fabrication of the ILM proceeds similarly to that of the first EAM previously described except that a periodic grating structure 37 is etched into the laser section 35 prior to overgrowth with p-doped indium phosphide, that a further region 39 is proton implanted to give electrical isolation between the laser section and the modulator section and that pattern-etching of the gold contact is carried out so as to produce separate contacts 40 and 41 respectively to the laser section 35 and the modulator section 36.

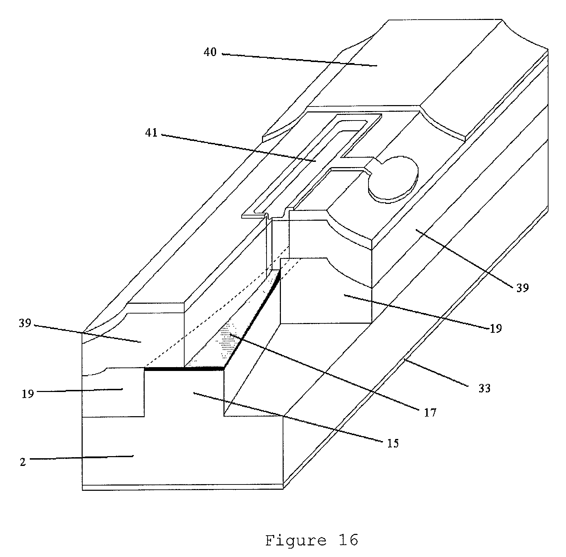

Figure 15 shows this ILM in diagrammatic perspective view, and Figure 16 shows the slightly modified structure that is obtained if the general procedure follows that for the second EAM described, instead of the first.

**Claims**

1. An optical monomode guided-wave device having an active region with a mode size small compared with that of an optical fibre integrated with at least one passive spot size adjuster which has an optical core that tapers simultaneously from a width and height substantially equal to those of the active region adjacent to that region to a width large compared with the width of the active region and a thickness substantially smaller than the thickness of the active region at a position remote from that region **characterised in that** it is a buried hetero-structure device, *that* the optical core tapers smoothly in both width and height, *that* the dimensions of the core are such that there is an optical transmission mode for which the effective refractive index difference between the mode and any other mode is large enough to ensure that no more than 20% of light entering one end of the guided wave device **in that** mode will (or would) be lost (or gained) by radiation *and that* the mode size at the distal end of the spot-size adjuster is substantially larger than its mode size in the active region.

2. An optical guided-wave device in accordance with claim 1, being an electroabsorption modulator.

3. An optical guided-wave device in accordance with claim 1, being an integrated laser modulator

4. An optical guided-wave device as claimed in any one of claims 1-3 in which the effective refractive index difference for the said mode is everywhere at least 0.001.

5. An optical guided-wave device in accordance with any one of claims 1-6 in which the width of the core tapers to at least 5 times its value in the active device.

6. An optical guided-wave device in accordance with any one of claims 1-5 in which the height of the core tapers below 0.4 times its value in the active device.

7. An optical guided-wave device in accordance with any one of claims 1-6 in which the composition of the optical core also varies smoothly through the spot size adjuster such that its bandgap is substantially greater than that in the active region.

8. An optical guided-wave device in accordance with any one of claims 1-7 in which the cladding material (including the initial surface on which the ridge was deposited) is indium phosphide and the ridge is formed of a plurality of layers of an alloy semiconductor comprising at least two of indium, gallium, and aluminium, and at least one of phosphide and arsenide.

9. An optical guided-wave device in accordance with any one of claims 1-8 being a device that light passes through and which is integrated with two said spot size converters, one at the input and one at the output side of the device.

10. A method of making the structure claimed in claim 1 which is *characterised* **by** the steps of

    (i) applying to a semiconductor substrate at least one pair of bands of a deposition-resist material between which a channel of the substrate is exposed, the channel having a first section where its own width and the widths of the bands are both uniform and at least one section where the bands taper inwardly and/or the channel tapers outwardly from at least one of the ends of the first section;
    (ii) forming a ridge of at least one semiconductor optical core material in the channel by a metal-organic vapour phase epitaxy technique under mass-transport-limited conditions such that the thickness of epitaxial growth is greater where the width of the channel is less;
    (iii) masking and etching the ridge so made to produce a core with controlled dimensions including a width everywhere substantially less than the corresponding width of the channel and also including the specified tapers; and
    (iv) enclosing the etched ridge in optical cladding material.

11. A process as claimed in claim 10 comprising forming the bands by first depositing a uniform layer of deposition-resist material on a semiconductor chip substrate, printing and patterning a photoresist on the uniform layer corresponding to the desired bands, and etching to reproduce the photoresist pattern in the deposition-resist material.

12. A process as claimed in claim 10 or claim 11 in which the cladding material (including the initial surface on which the ridge is deposited) is indium phosphide and the ridge is formed of a plurality of layers of an alloy semiconductor comprising at least two of indium, gallium, and aluminium, and at least one of phosphide and arsenide.

13. A process as claimed in any one of claims 10-12 in which the ridge is initially deposited with pronounced thickness maxima close to its edges, and a central area where the thickness is substantially uniform across its width and in which the etching step completely removes the outer, thicker parts leaving the finished ridge of substantially uniform thickness across its width.

Figure 1

Figure 2

B

1

14

Figure 3

8

14

17

9

18

15

16

Figure 4

Figure 5

Figure 6

Figure 7

— 27 —

21

17

20

15

Figure 8

Figure 9

Figure 10

Figure 11

Figure 12

-2-

Figure 13

Figure 14

Figure 15

Figure 16